# EUROPÄISCHE PATENTSCHRIFT

(11) **EP 1 313 126 B1**
(45) Veröffentlichungstag und Bekanntmachung des Hinweises auf die Patenterteilung: **28.05.2008**
(21) Anmeldenummer: 02025492.6
(22) Anmeldetag: 15.11.2002
(51) Int. Cl.: H01J 37/244, H01J 37/28

(54) **Detektoranordnung und Detektionsverfahren**
Detector arrangement and detecting process
Dispositif détecteur et procédé de détection

(30) Priorität: 16.11.2001 DE 10156275
(43) Veröffentlichungstag der Anmeldung: 21.05.2003
(73) Patentinhaber: Carl Zeiss NTS GmbH, 73447 Oberkochen (DE)
(72) Erfinder: Knippelmeyer, Rainer, Dr., 73431 Aalen (DE)
(74) Vertreter: Schorr, Frank Jürgen

(56) Entgegenhaltungen:
- DE-A- 2 436 160
- US-A- 5 866 905

## Beschreibung

Die Erfindung betrifft eine Detektoranordnung und ein Detektionsverfahren.

Die Detektoranordnung und das Detektionsverfahren sind insbesondere zur Erfassung einer in einem Strahl geladener Teilchen enthaltenen Ortsinformation vorgesehen. Die geladenen Teilchen können insbesondere Elektronen sein, und die Erfindung betrifft entsprechend insbesondere das Feld der Elektronenmikroskopie.

Die Patentschrift US 5,866,905 zeigt ein Elektronenmikroskop mit einer Multi-Channel-Detektoranordnung zur Ausgabe eines Bildes einer Intensität von auf die Detektoranordnung treffenden geladenen Teilchen, und eine Steuerung zum Empfang des Bildes.

Bei einem herkömmlichen Rasterelektronenmikroskop ("scanning electron microscope", SEM), wie es beispielsweise aus US 5,578,821 bekannt ist, wird ein Elektronenstrahl auf einen Punkt (Pixel) des zu untersuchenden Objekts fokussiert. Durch die Elektronen des fokussierten Strahls in dem Objekt erzeugte Rückstreuelektronen, Sekundärelektronen oder Transmissionselektronen werden durch eine hierfür jeweils vorgesehene Detektoranordnung registriert. Hierbei ist ein Deflektor vorgesehen, um den Ort, an dem der fokussierte Strahl auf das Objekt trifft, zu verlagern. Die jeweiligen Detektoranordnungen selbst sind nicht ortsauflösend, sondern erfassen integral sämtliche Rückstreu-, Sekundär- bzw. Transmissionselektronen. Ein Ortsinformation des untersuchten Objekts umfassendes Bild kann allerdings dadurch erhalten werden, in dem eine von einer Detektoranordnung registrierte Intensität an Rückstreu-, Sekundär- bzw. Transmissionselektronen dem durch den Deflektor bestimmten Ort, an dem der fokussierte Strahl auf das Objekt trifft, zugeordnet wird. Durch die Deflektoreinrichtung wird der Strahl nacheinander an verschiedene Orte (Pixel) des Objekts gerastert bzw. gescannt, und es werden die den verschiedenen Orten zugeordneten gemessenen Intensitäten registriert, um aus diesen das Ortsinformationen umfassende Bild des Objekts zusammenzusetzen. Ein solches Detektionsverfahren, bei dem zu einem jeden Zeitpunkt die Intensität von geladenen Teilchen, die von lediglich einem Pixel des Objekts herrühren, erfaßt wird, ist sehr zeitaufwendig.

US 6,087,659 offenbart eine elektronenmikroskopische Detektoranordnung, bei der ein räumlich ausgedehntes Feld auf dem Objekt mit Primärelektronen bestrahlt wird, und bei dem mittels einer Abbildungsoptik aus dem Objekt austretende Sekundärelektronen auf einen ortsauflösenden Detektor abgebildet werden. Hierdurch ist, im Unterschied zu dem in US 5,578,821 gezeigten System, ein sequentielles Abtasten von lediglich einzelnen Pixeln mittels eines Deflektors nicht notwendig, ist vielmehr möglich, eine Vielzahl von Pixeln des Objekts gleichzeitig mit dem ortsauflösenden Detektor zu erfassen. Ein Ortsinformation enthaltendes Bild des Objekts kann somit von dem ortsauflösenden Detektor auf einmal ausgegeben werden, ohne daß es nötig ist, dieses Bild durch zeitlich sequentielles Zusammensetzen von einzelnen Pixeln zu konstruieren.

Wird bei einem solchen Verfahren allerdings beispielsweise ein herkömmlicher CCD-Detektor als ortsauflösender Detektor eingesetzt, so ist die Menge an Ortsinformation von dem Objekt, welche pro Zeiteinheit gewonnen werden kann, gleichwohl begrenzt und wird für fortgeschrittene Anwendungen als zu gering empfunden.

Demgemäß ist es eine Aufgabe der vorliegenden Erfindung eine Dektoranordnung und ein Detektionsverfahren zur Erfassung einer in einem Strahl geladener Teilchen enthaltenen Ortsinformation vorzuschlagen, bei dem eine Menge an Ortsinformation, welche pro Zeiteinheit gewonnen werden kann, erhöht ist.

Ferner ist es eine Aufgabe der Erfindung, eine Elektronenmikroskopievorrichtung, insbesondere ein Rückstreuelektronenmikroskop oder/und ein Sekundärelektronenmikroskop oder/und ein Transmissionselektronenmikroskop oder/und ein Photoelektronenmikroskop, vorzuschlagen, welches die Detektion von Ortsinformation des Objekts mit erhöhter Rate erlaubt.

Die Erfindung geht aus von einer Detektoranordnung zur Erfassung einer in einem Strahl geladener Teilchen enthaltenen Ortsinformation mit wenigstens einem ortsauflösenden Detektor zur Ausgabe eines die Information umfassenden Bildes und einer Steuerung zum Empfang des von dem Detektor ausgegebenen Bildes. Zur Erzeugung des Bildes in dem Detektor wird dieser belichtet, das heißt es wird der die Ortsinformation enthaltende Teilchenstrahl auf eine Detektionsfläche des Detektors gerichtet, und der Detektor integriert zeitlich eine ortsabhängige Verteilung an Strahlungsintensität, die auf die Detektionsfläche trifft. Diese ortsabhängig integrierte Intensität an auftreffender Strahlung ist die Grundlage für das von dem Detektor ausgegebene Bild.

Das Bild enthält die Ortsinformation, die der ortsabhängig integrierten Intensität entspricht. Das Bild kann beispielsweise elektronisch dargestellt sein, insbesondere als Binärdaten oder als Analogsignal.

Die Erfindung zeichnet sich dadurch aus, daß eine Mehrzahl von ortsauflösenden Detektoren vorgesehen ist und daß ferner eine Ablenkeinrichtung vorgesehen ist, um den Strahl geladener Teilchen auf die Detektionsfläche eines aus der Mehrzahl von Detektoren auswählbaren Detektors zu richten, wobei die Ablenkeinrichtung durch die Steuerung ansteuerbar ist, um den Detektor, auf den der Strahl zu richten ist, aus der Mehrzahl von Detektoren auszuwählen.

Der Erfindung liegt folgende Erkenntnis zugrunde:

Bei der herkömmlichen Detektoranordnung mit lediglich einem einzigen ortsauflösenden Detektor ist die Rate, mit der Ortsinformation enthaltende Bilder aus dem Detektor ausgelesen werden können, dadurch begrenzt, daß der Detektor eine gewisse Totzeitdauer aufweist, während der er selbst weitere Bildinformation nicht gewinnen, das heißt auf seine Detektionsfläche treffende Strahlungsintensität nicht weiter integrieren kann. Während dieser Totzeitdauer befindet sich der Detektor in einem Totzeitstatus.

Diese Totzeitdauer überlappt im allgemeinen zeitlich wenigstens teilweise mit der Zeitdauer, die nötig ist, um ein Ortsinformation umfassendes Bild von dem Detektor in die zugehörige Steuerung zu übertragen. Während dieser Totzeitdauer stellt der Strahl geladener Teilchen Ortsinformation bereit, die allerdings von dem Detektor nicht detektiert werden kann. Somit könnte die Menge an Ortsinformation, die pro Zeiteinheit durch die Detektoranordnung detektierbar ist, dadurch erhöht werden, daß die Zeit reduziert wird, während der der Strahl geladener Teilchen Ortsinformation bereitstellt und während der diese allerdings nicht detektiert wird.

Die Erfindung sieht deshalb die Bereitstellung mehrerer ortsauflösender Detektoren vor. Der Strahl geladener Teilchen ist zu einem jeden Zeitpunkt vorzugsweise nur auf die Detektionsfläche eines einzigen Detektors gerichtet. Allerdings ist eine Ablenkeinrichtung vorgesehen, mittels der der Strahl ablenkbar ist, so daß er wahlweise auf die Detektionsfläche eines jeden der mehreren Detektoren gerichtet werden kann. Es ist dann möglich, während der Totzeitdauer eines zuvor belichteten Detektors den Strahl der geladenen Teilchen auf einen anderen der Detektoren zu richten, der sich gerade nicht in einem Totzeitstatus befindet, um die in dem Strahl geladener Teilchen enthaltene Ortsinformation auch dann zu detektieren, wenn der zuvor belichtete Detektor in seinem Totzeitstatus ist.

Vorteilhafterweise ist die Anzahl der bereitgestellten Detektoren so bemessen, daß im wesentlichen ständig ein Detektor zur Belichtung bereitsteht, das heißt daß im wesentlichen ständig ein Detektor sich nicht in seinem Totzeitstatus befindet. Vorteilhafterweise ist die Anzahl der Detektoren hierbei bestimmt durch ein auf die nächst größere ganze Zahl aufgerundetes Verhältnis aus Totzeitdauer geteilt durch Belichtungszeit der Detektoren.

Die Detektoranordnung kann zur Beobachtung eines Objekts eingesetzt werden, welches sich zeitlich schnell ändert. Es können dann mit der Detektoranordnung mehr Bilder pro Zeiteinheit aufgenommen werden, als dies mit einer herkömmlichen Detektoranordnung mit lediglich einem einzigen Detektor aufgrund der Totzeitdauer des Detektors möglich wäre.

Zur Beobachtung von Objekten umfaßt die Detektoranordnung vorzugsweise eine Abbildungsoptik, um das Objekt oder ein auf andere Weise erzeugtes Zwischenbild des Objekts unter Zuhilfenahme des Strahls geladener Teilchen auf die Detektionsfläche des Detektors abzubilden.

Die Detektoranordnung ist ferner für die schnelle Beobachtung statischer oder lediglich langsam sich zeitlich veränderlicher Objekte einsetzbar. Hierzu bildet die Abbildungsoptik vorzugsweise lediglich einen Teilbereich des Objekts auf die Detektionsflächen der Detektoren ab. Es ist dann vorgesehen, daß die Abbildungsoptik durch die Steuerung derart ansteuerbar ist, daß der auf die Detektionsfläche abgebildete Teilbereich des Objekts änderbar ist. Es ist somit beispielsweise möglich, im wesentlichen zeitgleich mit einer Änderung der Auswahl des gerade belichteten Detektors auch den auf diesen Detektor abgebildeten Teilbereich des Objekts zu ändern und somit nach und nach eine Vielzahl von einander benachbarten Teilbildern des Objekts zu erzeugen. Die Änderung des auf den Detektor abgebildeten Teilbereichs des Objekts kann man beispielsweise verfolgen, indem das Objekt relativ zu der Detektoranordnung mechanisch verfahren wird. Es ist jedoch auch möglich, die Änderung des auf den Detektor abgebildeten Teilbereichs alleine durch die Änderung von optischen Parametern der Abbildungsoptik oder/und kombiniert durch die Änderung der optischen Parameter und die mechanische Verlagerung durchzuführen.

Die auf die Detektionsfläche abgebildeten geladenen Teilchen können beispielsweise Ionen oder auch Positronen sein, vorzugsweise wird die Detektoranordnung jedoch für den Nachweis von Elektronen insbesondere in der Elektronenmikroskopie eingesetzt. Vorzugsweise sind die nachgewiesenen Elektronen hierbei Rückstreuelektronen, Sekundärelektronen, Transmissionselektronen oder Photoelektronen.

Zur Erzeugung der auf die Detektionsfläche überführten geladenen Teilchen ist vorzugsweise eine Beleuchtungseinrichtung vorgesehen, welche wenigstens einem Teilbereich des Objekts Energie zuführt, um die geladenen Teilchen aus diesem Teilbereich des Objekts austreten zu lassen. Die Beleuchtungseinrichtung kann eine Elektronenquelle oder eine Photonenquelle oder eine Ionenquelle sein.

Gemäß einer bevorzugten Ausführungsform zur Beobachtung schnell veränderlicher Vorgänge des Objekts ist die Beleuchtungsanordnung eine von der Steuerung angesteuerte gepulste Beleuchtungsanordnung. Die Steuerung ändert dann die Auswahl des Detektors, auf den das Objekt mittels des Strahls geladener Teilchen abgebildet wird, vorzugsweise immer dann, wenn die Beleuchtungseinrichtung eine vorbestimmte Anzahl von Energiepulsen und insbesondere genau einen Energiepuls auf das Objekt abgegeben hat.

Abgesehen von der Beobachtung von Elektronen, die unmittelbar in oder an der Oberfläche des zu untersuchenden Objekts erzeugt werden, kann die Detektoranordnung zur Beobachtung von geladenen Teilchen, insbesondere Elektronen, welche Ortsinformation eines Objekts tragen, eingesetzt werden, welche über einen Zwischenprozeß entstehen. Ein solcher Zwischenprozeß kann beispielsweise ein lichtoptischer Zwischenprozeß sein, indem das zu beobachtende Objekt lichtoptisch auf einen Photonen-Elektronen-Konverter abgebildet wird, welcher die von dem Objekt stammenden Photonen ortsabhängig in Elektronen umwandelt, welche dann mit der Abbildungsoptik auf die Detektionsflächen der Detektoren abgebildet werden. Es ist somit möglich, mit hoher Rate Bilder eines lichtoptisch beobachteten Objekts aufzunehmen.

Die Abbildungsoptik stellt vorzugsweise eine Bildebene bzw. Bildfläche bereit, in der die in dem Teilchenstrahl enthaltene Ortsinformation zu einer besonders hohen Ortsabhängigkeit der Teilchenintensität führt, und vorzugsweise sind die Detektionsflächen der mehreren Detektoren im wesentlichen in dieser Bildebene bzw. Bildfläche angeordnet. Die Bildfläche hat hierbei nicht notwendigerweise die Gestalt einer planen Ebene, sondern kann auch die Gestalt einer im Raum gekrümmten Fläche aufweisen. Es ist vorgesehen, die mehreren Detektionsflächen eindimensional in einer Reihe nebeneinander anzuordnen und entsprechend die Ablenkeinrichtung derart auszubilden, daß sie den Teilchenstrahl in lediglich einer Richtung quer zu dessen Strahlrichtung auslenkt. Es ist jedoch ebenfalls vorteilhaft, die Detektionsflächen in einem zweidimensionalen Feld nebeneinander anzuordnen und entsprechend die Ablenkeinrichtung so auszubilden, daß sie den Teilchenstrahl in zwei unabhängige Richtungen quer zur Strahlrichtung auslenken kann.

Der Detektor ist vorzugsweise ein Halbleiterdetektor, insbesondere ein CCD-Detektor oder/und ein CID-Detektor.

Ausführungsformen der Erfindung werden nachfolgend anhand von Figuren erläutert. Hierbei zeigt:
- Figur 1: eine erste Ausführungsform einer erfindungsgemäßen Detektoranordnung in schematischer Darstellung,
- Figur 2: ein Zeitschema zur Ansteuerung von Detektoren der in Figur 1 gezeigten Detektoranordnung,
- Figur 3: eine zweite Ausführungsform der erfindungsgemäßen Detektoranordnung in schematischer Darstellung als Sekundärelektronenmikroskop,
- Figur 4: eine dritte Ausführungsform der erfindungsgemäßen Detektoranordnung in schematischer Darstellung als Transmissionselektronenmikroskop,
- Figur 5: eine vierte Ausführungsform der erfindungsgemäßen Detektoranordnung in schematischer Darstellung als Photoelektronenmikroskop,
- Figur 6: noch eine weitere Ausführungsform der Detektoranordnung und
- Figur 7: eine Variante des in Figur 2 gezeigten Ansteuerungsschemas für Detektoren.

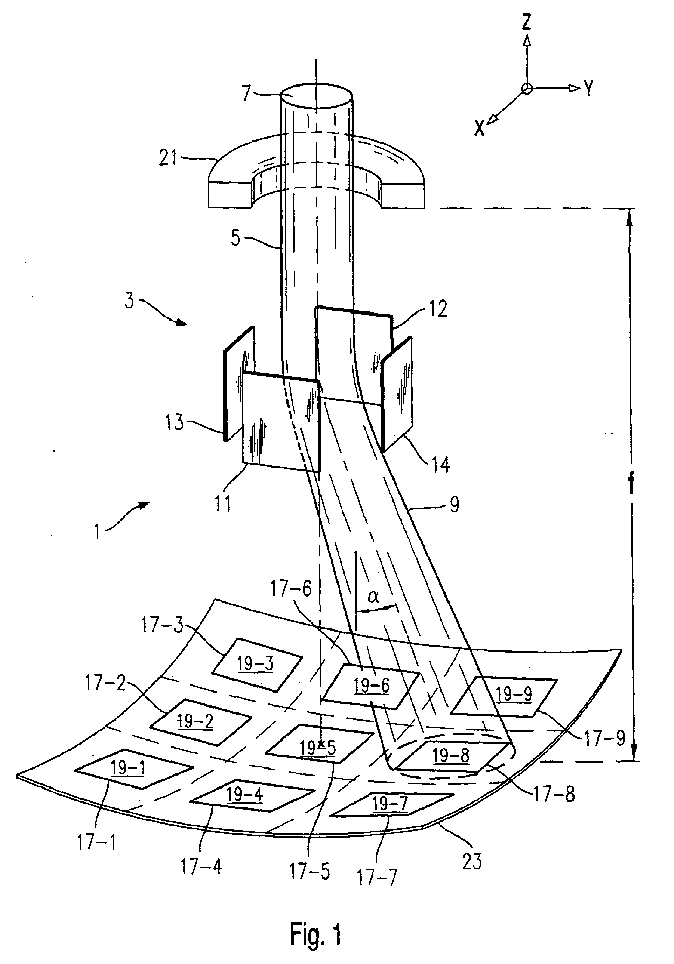

In Figur 1 ist eine Detektoranordnung 1 in schematischer perspektivischer Darstellung gezeigt.

Die Detektoranordnung 1 umfaßt eine Ablenkeinrichtung 3 für geladene Teilchen, nämlich hier Elektronen, welche als Strahl 5 mit einem festen Strahlquerschnitt 7 parallel zu einer z-Achse in die Ablenkeinrichtung 3 einfallen und aus dieser als abgelenkter Strahl 9 wieder herauskommen. Die Ablenkeinrichtung 3 ist eine elektrostatische Ablenkeinrichtung und umfaßt zwei sich bezüglich des einfallenden Strahls in einer x-Richtung gegenüberliegende Elektroden 11 und 12 sowie zwei sich bezüglich des einfallenden Strahls 5 in einer y-Richtung gegenüberliegende Elektroden 13 und 14. Die Elektrodenpaare 11, 12 bzw. 13, 14 sind von einer in der Figur 1 nicht dargestellten Steuerung ansteuerbar, um zwischen den Elektrodenpaaren ein elektrisches Feld zu erzeugen, welches den Strahl 5 orthogonal zu der Strahlrichtung des einfallenden Strahls 5 ablenkt. In Figur 1 ist an das Elektrodenpaar 11, 12 eine Spannung von in etwa 0 Volt angelegt, während an das andere Elektrodenpaar 13, 14 eine solche Spannung angelegt ist, daß das elektrische Feld zwischen den Elektroden 13 und 14 den einfallenden Strahl 5 um einen Winkel α in y-Richtung ablenkt.

Mit Abstand in z-Richtung von der Ablenkeinrichtung 3 sind neun ortsauflösende Elektronendetektoren 17 angeordnet, deren Detektionsflächen 19 in Projektion entlang der z-Achse in einem Feld mit gleichen Abständen in x- bzw. y-Richtung zwischen benachbarten Detektionsflächen angeordnet sind.

Bei durch die Ablenkeinrichtung 3 nicht abgelenktem einfallendem Strahl 5 würde dieser mittig auf die Detektionsfläche 19-5 des zentral in dem Feld aus Detektoren angeordneten Detektors 17-5 treffen. Bei der in Figur 1 dargestellten Auslenkung des Strahls 5 um den Winkel α trifft der aus der Ablenkeinrichtung 3 ausfallende Strahl 9 mittig auf die Detektionsfläche 19-8 des in y-Richtung neben dem zentralen Detektor 17-5 angeordneten Detektors 17-8. Die Ablenkeinrichtung 3 ist derart ansteuerbar, daß der einfallende Strahl 5 so ablenkbar ist, daß er wahlweise auf eine jede Detektionsfläche 19 der neun Detektoren 17 gerichtet werden kann.

Ein jeder der Detektoren 17 ist dazu vorgesehen, daß er die Intensität an auf seine Detektionsfläche 19 treffenden geladenen Teilchen während einer Belichtungszeitdauer t_{B} des Detektors 17 ortsabhängig integriert. Damit dient ein jeder Detektor 17 dazu, in dem einfallenden Strahl 5 enthaltene Ortsinformation zu erfassen. Um diese Ortsinformation mit möglichst hohem Kontrast zu erfassen, ist in dem Strahlengang vor der Ablenkeinrichtung 3 eine Magnetlinse 21 vorgesehen, welche auf den einfallenden Strahl 5 fokussierend wirkt. Hierbei ist angenommen, daß der einfallende Strahl 5 ein aus dem Unendlichen kommender Parallelstrahl ist, und ein Abstand zwischen der Magnetlinse 21 und dem Feld Detektoren 17 ist so bemessen, daß er in etwa gleich einer Brennweite f der Magnetlinse 21 ist. Ferner sind die jeweils planen Detektionsflächen 19-3 annähernd auf einer Bildfläche in Gestalt einer Kugelschale 23 angeordnet, deren Kugelmittelpunkt im Zentrum der Magnetlinse 21 liegt. Somit entsteht auf einer jeden Detektionsfläche 19, wenn die Ablenkeinrichtung 3 den Strahl 9 auf diese richtet, ein im wesentlichen scharfes Bild, der in dem Strahl 5 enthaltenen Ortsinformation.

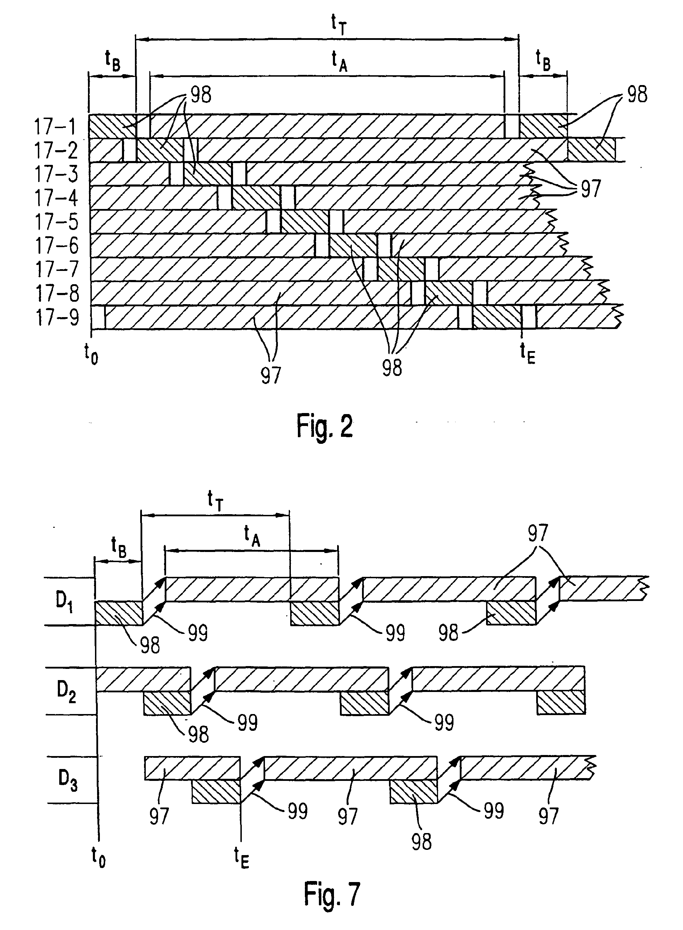

Die Detektoren 17 sind jeweils Halbleiterdetektoren vom CCD-Typ, vor deren sensitiver Fläche ein Szintillator angeordnet ist, um die auftreffenden geladenen Teilchen in Photonen umzuwandeln, die wiederum den Halbleiterdetektor anregen. Ein Ansteuerschema für die Detektoren 17 ist in Figur 2 dargestellt. Um bei einer gegebenen Anwendung und Intensität des Strahls 5 ein Bild mit ausreichendem Kontrast in dem Detektor 17 integrieren zu können, ist eine Belichtungszeitdauer t_{B} vorgesehen. Nach dem Ende der Belichtungszeitdauer wird das in dem Detektor 17 akkumulierte ortsabhängige Bild an die Steuerung zu übertragen. Hierfür ist eine mit t_{A} bezeichnete Übertragungszeitdauer 97 notwendig. Nach der Übertragung des Bildes als analoge oder digitale elektronische Signale an die Steuerung wird der Detektor zurückgesetzt und kann sodann erneut belichtet werden. In einer mit t_{T} Totzeitdauer zwischen einer vorangehenden Belichtungszeitdauer t_{B} und einer darauffolgenden Belichtungszeitdauer t_{B} findet somit ein Beginn der Datenübertragung, die Datenübertragung selbst und das Zurücksetzen des Detektors statt. Während dieser Totzeitdauer t_{T} kann der Detektor keine weitere Elektronenintensität integrieren und befindet sich somit in einem Totzeitstatus.

Bei dem in Figur 2 gezeigten Zeitschema ist die Totzeitdauer t_{T} wesentlich größer als die Belichtungszeitdauer t_{B}.

Zu Beginn t₀ des Steuerungszyklus sei die Ablenkeinrichtung derart angesteuert, daß der Strahl auf die Detektionsfläche 19-1 des Detektors 17-1 gerichtet ist. Während der in Figur 2 mit 98 bezeichneten Belichtungszeitdauer t_{B} dieses Detektors 17-1 bleibt der Strahl 9 auf diesen Detektor gerichtet, und die Intensität an geladenen Teilchen in dem Strahl 9 wird durch den Detektor 17-1 ortsabhängig integriert. Nach Beenden der Belichtungszeitdauer t_{B} des Detektors 17-1 wird die Ablenkeinrichtung 3 von der Steuerung derart angesteuert, daß der zur Belichtung mit dem Strahl ausgewählte Detektor von dem zuvor belichteten Detektor 17-1 geändert wird auf den nunmehr belichteten Detektor 17-2. Die Änderung des ausgewählten Detektors durch die Ablenkeinrichtung 3 erfolgt im wesentlichen instantan und der Detektor 17-2 wurde vorangehend bereits zurückgesetzt, so daß er, nachdem der Strahl auf seine Detektionsfläche gerichtet ist, im wesentlichen sofort mit der Belichtung beginnen kann. Nach dem Ende der Belichtungszeitdauer t_{B} des Detektors 17-2 wird die Auswahl des belichteten Detektors erneut geändert, und die Ablenkeinrichtung 3 lenkt den Strahl sodann auf den nächsten zuvor zurückgesetzten Detektor 17-3, welcher daraufhin mit seiner Belichtung beginnt. Dieses Verfahren wird fortgeführt, so daß nach und nach sämtliche Detektoren 17-1 bis 17-9 an einem Zeitpunkt t_{E} zeitversetzt belichtet wurden. Der Zeitpunkt t_{E} fällt dabei zusammen mit dem Ende der Totzeitdauer t_{T} des ersten Detektors 17-1. Dies bedeutet, daß zum Zeitpunkt t_{E} der Detektor 17-1 wieder bereit für eine erneute Belichtung ist. Entsprechend wird nach dem Ende der Belichtungszeitdauer t_{B} des Detektors 17-9 zum Zeitpunkt t_{E} die Ablenkeinrichtung 3 derart angesteuert, daß sie den Strahl nicht mehr auf den zuletzt belichteten Detektor 17-9, sondern nunmehr wieder auf den Detektor 17-1 lenkt, der von da an belichtet wird.

Durch dieses in Figur 2 gezeigte Ansteuerschema für die neun Detektoren 17 ist es somit möglich, trotz der im Vergleich zu der Belichtungszeitdauer t_{B} langen Totzeitdauer t_{T} der Detektoren im wesentlichen ständig Bildinformation aus dem Strahl 5 zu gewinnen.

Es wird also der Strahl 5 zeitlich nacheinander auf die verschiedenen Detektionsflächen der Detektoren gerichtet, und die Detektoren 17 finden sich zeitlich nacheinander in ihrem Belichtungszustand. Entsprechend sind auch die Übertragungszeitdauern t_{A} der einzelnen Detektoren 17 in dem Schema der Figur 2 zeitlich versetzt zueinander angeordnet.

Die während der Übertragungszeitdauern t_{A} zur Steuerung übertragenen Bilddaten werden von der Steuerung in einen Speicher übertragen. In dem Speicher werden die Bilder der einzelnen Detektoren in jeweils verschiedenen Speicherbereichen abgelegt, wobei eine Zuordnung zwischen den Speicherbereichen und den jeweiligen Detektoren besteht, so daß die einzelnen von den Detektoren gewonnenen Bilder später analysiert werden können.

Nachfolgend werden Varianten der Erfindung erläutert. Hierbei sind Komponeten, die hinsichtlich ihrer Funktion und ihres Aufbaus Komponeten der in den Figuren 1 und 2 erläuterten Ausführungsform entsprechen, mit den gleichen Bezugsziffern wie in den Figuren 1 und 2 bezeichnet, zur Unterscheidung jedoch mit einem zusätzlichen Buchstaben versehen.

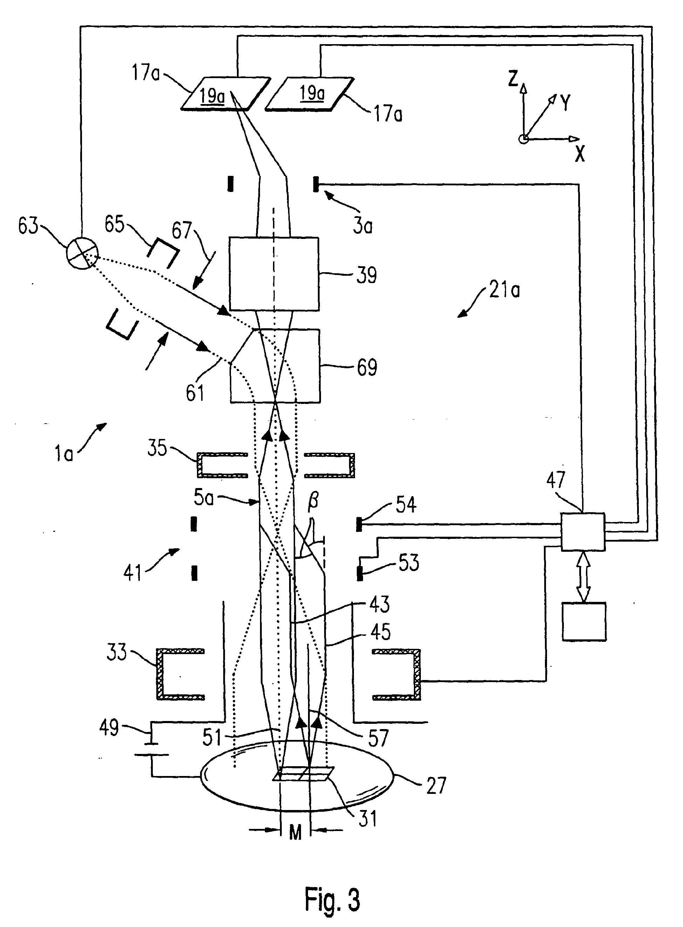

Eine in Figur 3 schematisch dargestellte Detektoranordnung 1a dient zur Erstellung eines Bildes von räumlichen Strukturen eines Objekts 27, nämlich einen sich im Fertigungsprozeß befindlichen Halbleiterwafers 27. Das Bild der räumlichen Strukturen des Objekts 27 ist ein elektronisches Bild, dessen Bilddaten in einem Speicher 29 gespeichert werden.

Die Detektoranordnung 1a ist als ein Sekundärelektronenmikroskop aufgebaut, welches eine Abbildungsoptik 21a umfaßt, um ein räumlich begrenztes Feld 31 auf der Oberfläche des Objekts 27 auf eine Detektionsfläche 19a eines Detektors 17a aus einer Mehrzahl von Detektoren 17a abzubilden. Hierzu umfaßt die Abbildungsoptik 21a eine objektnahe Fokussierlinse 33, eine weitere Fokussierlinse 35, eine Nachvergrößerungsoptik 39 und eine Ablenkeinrichtung 41.

In Figur 3 sind Trajektorien 43, 45 zweier Sekundärelektronen, die von einem Ort des Feldes 31 unter verschiedenen Winkeln austreten, symbolisch dargestellt. Die mit einer kinetischen Energie zwischen 0eV und etwa 50eV aus dem Objekt 27 austretenden Sekundärelektronen werden zunächst auf eine kinetische Energie von etwa 20keV beschleunigt. Die Beschleunigung erfolgt durch ein elektrisches Feld, welches zwischen dem Objekt 27 und einer vor dem Objekt angeordneten Elektrode 49 bereitgestellt ist. Nach der Beschleunigung durchlaufen die Elektronen die objektnahe Fokussierlinse 33 und die weitere Fokussierlinse 35. Ein Strahl 5a aus Sekundärelektronen 43, 45 enthält, nachdem er die Fokussierlinse 35 durchsetzt hat, Ortsinformation über das Objekt 27, da die Intensität, mit der Sekundärelektronen 43, 45 von der Probe 27 emittiert werden, aufgrund von Strukturen des Objekts 27 innerhalb des Feldes 31 ortsabhängig ist. Um diese Ortsinformation als Bild zu gewinnen, durchläuft der Strahl die Nachvergrößerungsoptik 39, die ein oder mehrere weitere elektronenoptische Linsen und andere Komponenten enthalten kann. Nach Durchlaufen der Nachvergrößerungsoptik 39 durchsetzt der Strahl 5a eine Ablenkeinrichtung 3a, welche von einer Steuerung 47 derart ansteuerbar ist, daß der Strahl die Detektionsfläche 19a eines durch die Steuerung 47 aus der Mehrzahl von Detektoren 17a ausgewählten Detektors trifft.

In Figur 3 sind lediglich zwei Detektoren 17a symbolisch dargestellt. Allerdings können hier drei oder mehr Detektoren vorgesehen sein, beispielsweise neun Detektoren in einer Anordnung, wie sie in Figur 1 dargestellt ist. Wesentlich ist, daß die Steuerung 47 einen der Detektoren auswählt, auf den die Ablenkeinrichtung 3a dann den Strahl 5a lenkt, um den ausgewählten Detektor zu belichten. Hierzu wird ebenfalls ein Belichtungsschema eingesetzt, das dem in Zusammenhang mit Figur 2 erläuterten Belichtungsschema entspricht. Das heißt, die verschiedenen Detektoren 17a werden zeitlich nacheinander belichtet, und die in einem jeden Detektor gespeicherten Intensitätsbilder werden während einer Totzeit des jeweiligen Detektors an die Steuerung 47 übertragen. Allerdings stehen während der Totzeit eines jeden Detektors 17a andere Detektoren 17a für die Belichtung und damit zur Gewinnung der ortsabhängigen Information in dem Strahl 5a zur Verfügung, so daß eine im wesentlichen ununterbrochene Gewinnung der Ortsinformation möglich ist.

Die von den einzelnen Detektoren 17a an die Steuerung 47 übertragenen Bilder werden von der Steuerung 47 in dem Speicher 29 in jeweils verschiedenen Speicherbereichen abgelegt.

Die Komponenten 33, 35 und 39 der Abbildungsoptik 21a sind bezüglich einer Hauptachse 51 der Detektoranordnung 1a im wesentlichen zentriert angeordnet. Allerdings ist das Feld 31, das auf eine der Detektionsflächen 19a abgebildet ist, bezüglich der Hauptachse 51 in einer x-Richtung quer zur Hauptachse 51 verlagerbar. Hierzu sind zwischen den beiden Fokussierlinsen 33 und 35 zwei Deflektoren 53 und 54 angeordnet. In Figur 3 ist eine Situation dargestellt, bei der das Zentrum des auf die Detektionsfläche 19a abgebildeten Felds 31 um eine Strecke M in x-Richtung von der Hauptachse 51 weg verlagert ist. Nach Durchlaufen der objektnahen Fokussierlinse 33 erstrecken sich die Trajektorien 43, 45 im wesentlichen parallel zu der z-Achse bzw. der Hauptachse 51. Der näher an dem Objekt angeordnete Deflektor 53 bewirkt eine Ablenkung der Trajektorien um einen Winkel β derart, daß die Elektronen in Richtung zur Hauptachse 51 hin verlaufen. Daraufhin bewirkt der entfernter von dem Objekt 27 angeordnete Deflektor 54 eine Ablenkung der Elektronen um einen Winkel -β derart, daß die Elektronen wieder parallel zu der z-Achse weiterverlaufen. Die Auslenkung M des Feldes 31 weg von der Hauptachse 51 ist somit durch den Abstand der beiden Deflektoren 53, 54 voneinander und den durch die beiden Deflektoren 53, 54 jeweils bereitgestellten Ablenkwinkel β gegeben.

Die objektnahe Fokussierlinse 33 ist durch die Steuerung 47 derart ansteuerbar, daß eine optische Achse 57 der für die Sekundärelektronen 43, 45 bereitgestellten Linsenwirkung um den Betrag M von der geometrischen Hauptachse 51 der Detektoranordnung in x-Richtung wegverlagert ist. Somit ist die objektnahe Fokussierlinse 33 eine Linse mit variabler optischer Achse ("variable axis lense"), welche auch als "moving objective lens", MOL bezeichnet wird. Eine solche Linse ist beispielsweise bekannt aus US 4,376,249 oder aus dem Artikel von E. Goto et al., OPTIC 48 (1977), Seiten 255ff.

Die objektnahe Fokussierlinse 33 und die Ablenker 53, 54 führen somit das um den Betrag M von der Hauptachse 51 ausgelenkte Feld 31 auf die Hauptachse 51 zurück, und zwar unter Beibehaltung einer Abbildungseigenschaft, so daß der die zweite Fokussierlinse 35 zur Hauptachse 51 zentriert durchsetzende Strahl 5a die Ortsinformation des um den Betrag M von der Hauptachse weg wegverlagerten Felds 31 trägt.

Das Untersuchungssystem arbeitet wie folgt:

In einem ersten Schritt wird ein erstes Feld 31 des Wafers 27 auf einen ersten der Detektoren 17a abgebildet, und dieser erste Detektor 17a wird während einer Belichtungszeitdauer t_{B} mit den in dem ersten Feld aus dem Objekt 27 austretenden Sekundärelektronen belichtet. Nach Ende der Belichtungszeitdauer t_{B} des ersten Detektors 17a wird die Ablenkeinrichtung 3a von der Steuerung 47 angesteuert, um den Strahl 5a auf einen weiteren zweiten Detektor 17a zu lenken, welcher sich gerade nicht in einem Totzeitstatus befindet. Gleichzeitig mit der Umschaltung des belichteten Detektors 17a werden auch die Ablenker 53 und 54 sowie die objektnahe Fokussierlinse 33 von der Steuerung 47 angesteuert, um ein benachbart zu dem ersten abgebildeten Feld angeordnetes zweites Feld des Wafers 27 durch die Abbildungsoptik 21a abzubilden. Somit entsteht in dem zweiten Detektor 17a das Bild des zweiten Felds auf der Oberfläche des Objekts 27. Dieser Vorgang wird mit weiteren Detektoren 17 und weiteren Feldern 31 wiederholt, bis sämtliche Detektoren 17a belichtet wurden. Zu einem solchen Zeitpunkt ist allerdings die Totzeitdauer des ersten Detektors 17a vorüber, so daß dieser Detektor wieder zur Belichtung zur Verfügung steht. Entsprechend wird die Ablenkeinrichtung 3a von der Steuerung 47 angesteuert, um den Strahl 5a wieder auf den ersten Detektor zu richten. Dieses Umschalten der Ablenkeinrichtung 3a erfolgt wiederum zeitgleich mit einem Umschalter der Ablenker 53 und 54 sowie der objektnahen Fokussierlinse 33 dahingehend, daß wiederum ein von den vorangehend abgebildeten Feldern verschiedenes weiteres Feld 31 der Objektoberfläche 27 durch die Optik 21a abgebildet wird.

Ein jedes somit von den Detektoren 17a registriertes Bild eines Teils der Objektoberfläche wird nach einem wie etwa in Zusammenhang mit Figur 2 erläuterten Schema an die Steuerung 47 übertragen und von dieser in dem Speicher 29 abgelegt, wobei ein jedes Bild in einem eigenen Teilbereich des Speichers abgelegt wird. Somit sind nach Abschluß der Untersuchung des Objekts 27 sämtliche von diesem gewonnene Bilder in dem Speicher 29 in digitaler Form enthalten und können somit einer nachfolgenden Analyse unterzogen werden.

Die Sekundärelektronen 43, 45 werden in dem Objekt 27 durch einen Primärelektronenstrahl 61 herausgelöst, welcher von einer Elektronenkanone 63, einer Magnetlinse 65 und einer Strahlformungsblende 67 geformt wird. Die kinetische Energie der Primärelektronen des Strahls 61 beträgt etwa 22keV. Mittels eines Strahlkombinators, beispielsweise eines Wien-Filters 69 wird der Primärelektronenstrahl 61 dem Sekundärelektronenstrahl 5a auf der Hauptachse 51 überlagert. Damit läuft der Primärelektronenstrahl 61 auf der Hauptachse 51 auf das Objekt 27 zu, durchsetzt hierbei die Fokussierlinse 35, die Ablenker 45, 53 und die objektnahe Fokussierlinse 33 der Reihe nach. Dabei erfährt auch der Primärelektronenstrahl eine gewisse Ablenkung durch die Ablenker 54 und 53, wobei die jeweiligen Ablenkwinkel nicht unbedingt mit den Ablenkwinkeln β bzw. -β für die Sekundärelektronen übereinstimmen müssen. Entsprechend ist die Strahlformungsblende 67 derart bemessen, daß auf dem Objekt 27 ein Teil der Objektoberfläche mit Primärelektronen beleuchtet wird, der größer ist als das Feld 31, das auf die Detektoren 17a abgebildet wird.

Die Steuerung 47 kann auch die Elektronenkanone 63 ansteuern, um die Intensität des Primärelektronenstrahls 61 einzustellen. Es ist dadurch möglich, bei einer gegebenen Belichtungszeitdauer t_{B} der Detektoren 17a eine optimale Belichtungsintensität einzustellen. Ferner ist es möglich, daß die Steuerung 47 die Elektronenkanone 63 derart ansteuert, daß diese Pulse an Primärelektronen ausgibt, so daß ebenfalls die Sekundärelektronen gepulst entstehen. Es ist dadurch möglich, besonders kurze Belichtungsdauern zu realisieren und Änderungen an der Struktur des Objekts 27 zu beobachten, welche in Zeitintervallen ablaufen, die kürzer sind als die Belichtungszeitdauern t_{B} der Detektoren 17a.

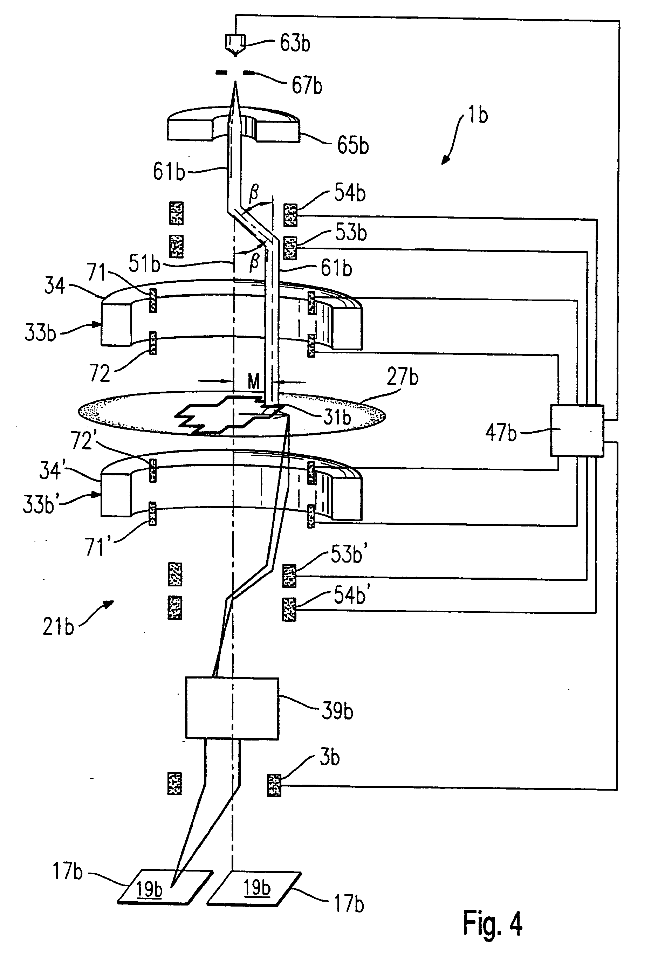

Eine in Figur 4 dargestellte Detektoranordnung 1b ist im Unterschied zu der in Figur 3 gezeigten Anordnung nicht als Sekundärelektronenmikroskop sondern als Transmissionselektronenmikroskop ausgebildet. Ein Primärelektronenstrahl 61b wird durch eine Elektronenkanone 63b, eine Strahlformungsblende 67b und eine Fokussierlinse 65b geformt und verläuft zunächst entlang einer Hauptachse 51b der Vorrichtung. Sodann durchläuft der Primärelektronenstrahl 61b nacheinander zwei Strahlablenker 54b und 53b, welche den Strahl nacheinander um einen Winkel β bzw. -β auslenken, so daß dieser nach Durchlaufen des Ablenkers 53b um einen Betrag M versetzt zur Hauptachse 51b in eine Fokussierlinse 33b eintritt. Die Fokussierlinse 33b umfaßt eine magnetische Rundlinse 34 und darin angeordnete Spulen 71, 72, um ein magnetisches Dipolfeld zu erzeugen, welches dem fokussierenden Feld der Rundlinse 34 derart überlagerbar ist, daß sich insgesamt ein fokussierendes Feld für den um den Betrag M von der Achse 51b ausgelenkten Primärelektronenstrahl 61b ergibt. Die Symmetrieachse dieses Feldes ist ebenfalls um den Betrag M bezüglich der Hauptachse 51b ausgelenkt. Damit beleuchten die Primärelektronen 61b ein Feld auf einer Probe 27b, welches ebenfalls um den Betrag M von der Hauptachse 51b weggelenkt ist.

Die auf eine Oberseite des Objekts 27b in dem beleuchteten Feld 31b auftreffenden Primärelektronen durchsetzen das Objekt 27b zum Teil und treten auf dessen anderer Seite als Transmissionselektronen aus. Die austretenden Transmissionselektronen werden durch eine Abbildungsoptik 21b auf Detektionsflächen 19b einer Mehrzahl von Detektoren 17b abgebildet. Die Abbildungsoptik 21b weist Komponenten auf, die bezüglich der Oberfläche des Objekts 27b im wesentlichen symmetrisch zu den Komponenten angeordnet sind, die den Primärelektronenstrahl 61b auf das Feld 31b richten. Entsprechend umfaßt auch die Abbildungsoptik 21b eine Fokussierlinse 33b' mit einer magnetischen Rundlinse 34b', in der Dipolspulen 72' und 71' angeordnet sind, sowie weiter zwei Ablenker 53b' und 54b'. Auch die Komponenten 71', 72', 53b' und 54b' der Abbildungsoptik 21b sind von der Steuerung 47b derart ansteuerbar, daß das um den Betrag M bezüglich der Hauptachse 51b ausgelenkte Feld 31b wieder auf die Hauptachse 51 zurückgeführt wird, bevor die Transmissionselektronen in eine Nachvergrößerungsoptik 39b eintreten. Nach Durchlaufen der Nachvergrößerungsoptik 39b durchsetzen die Transmissionselektronen eine Ablenkeinrichtung 3b, welche den Strahl Primärelektronen von der Hauptachse 51b derart weglenkt, daß er wahlweise auf einen der Detektoren 17b trifft, welche mit einem solchen Abstand von dem Objekt 27b angeordnet sind, daß dessen Oberfläche scharf auf die Detektoren abgebildet wird.

Auch bei der in Figur 4 dargestellten Ausführungsform werden die Detektoren 17b nach einem Zeitschema betrieben, wie dies in Zusammenhang mit der in Figur 3 bzw. Figur 2 erläuterten Ausführungsform beschrieben wurde. Mit diesem Transmissionselektronenmikroskop ist es möglich, in vergleichsweise kurzer Zeit ein vollständiges elektronenmikroskopisches Bild eines vergleichsweise großen Teils der Oberfläche eines Objekts aufzunehmen.

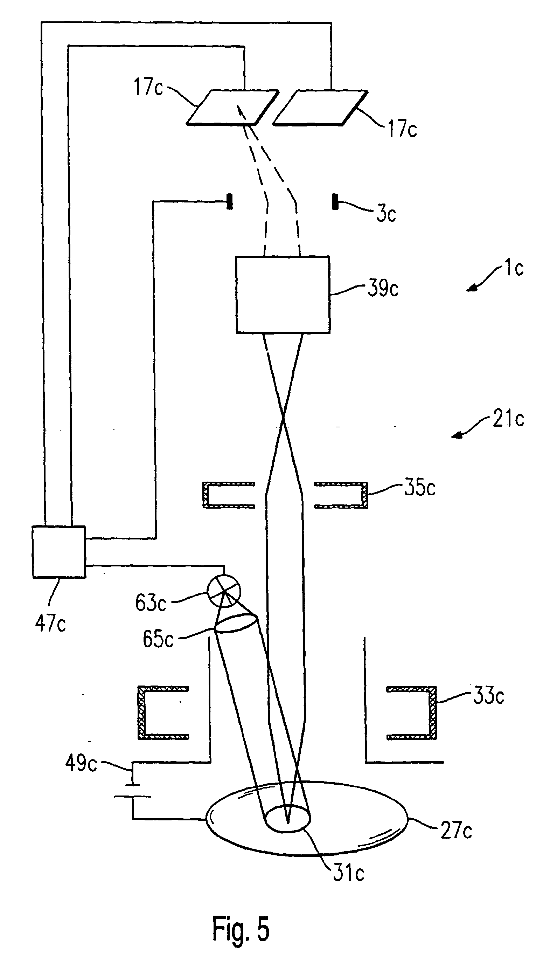

Figur 5 zeigt eine Detektoranordnung 1c, welche als Photoemissionselektronenmikroskop ausgebildet ist. Diese umfaßt eine Licht- bzw. Photonenquelle 63c, die von einer Steuerung 47c gepulst angesteuert wird und ein Feld 31c auf einer Probe 27c beleuchtet. Durch die Photonen der Photonenquelle 63c werden in dem Feld 31c Photolektronen aus der Probe 27c ausgelöst, welche mittels einer Elektrode 49c, an welcher ein entsprechendes Potential bezüglich der Probe 27c anliegt, beschleunigt werden und eine objektnahe Fokussierlinse 33c durchlaufen. Hiernach durchlaufen die Photoelektronen eine zweite Fokussierlinse 35c und daraufhin eine Nachvergrößerungsoptik 39c. Die objektnahe Fokussierlinse 33c, die zweite Fokussierlinse 35c und die Nachvergrößerungsoptik 39c wirken zusammen als eine Abbildungsoptik 21c, um das Feld 31c des Objekts 27c auf Detektoren 17c abzubilden. Zwischen der Nachvergrößerungsoptik 39c und den Detektoren 17c ist eine Ablenkeinrichtung 3c angeordnet, welche von der Steuerung 47c derart angesteuert wird, daß das Feld 31c wahlweise auf einen der Detektoren 17c abgebildet wird.

Im Unterschied zu den in Zusammenhang mit den Figuren 3 und 4 erläuterten Ausführungsformen ist bei dem Elektronenmikroskop der Figur 5 der auf die Detektoren 17c abgebildete Bereich 31c des Objekts 27c nicht bezüglich einer Hauptachse der Vorrichtung auslenkbar. Das Mikroskop 1c dient vornehmlich dazu, schnell veränderliche Strukturänderungen des Objekts 27c zu erfassen. Hierzu steuert die Steuerung 47c die Photonenquelle 63c und den Ablenker 3c in einer synchronisierten zeitlichen Abfolge an. Es wird die Ablenkeinrichtung 3c immer dann angesteuert, um das Feld 31c auf einen weiteren von dem vorangehend belichteten Detektor verschiedenen Detektor zu lenken, wenn genau ein Strahlungspuls von der Photonenquelle 63c erzeugt wurde. Somit entstehen zeitlich nacheinander Bilder des Objekts 27c in den verschiedenen Detektoren 17c. Aus diesen verschiedenen Detektoren werden die Bilder auch in einer zeitlichen Abfolge nacheinander, etwa nach einem Schema wie dies in Figur 2 dargestellt ist, ausgelesen. Insgesamt kann somit mit der Detektoranordnung 1c eine höhere Bildrate der zeitlich schnell veränderlichen Strukturänderung des Objekts 27c aufgenommen werden, als dies im Vergleich zu einer herkömmlichen Anordnung möglich wäre, die lediglich einen einzigen Detektor umfaßt.

Alternativ zu der vorangehenden Beschreibung der in Figur 5 dargestellten Ausführungsform als Photoelektronenmikroskop könnte die Quelle 63c auch eine lonenquelle sein und die Optik 65c könnte einen Ionenoptik sein, um dem Bereich 31c auf der Probe 27c Energie zuzuführen. Diese in Form von Ionen zugeführte Energie führt dann zu einer ortsabhängigen Emission von Elektronen in dem Bereich 31c der Probe 27c, welche mittels der Optik 21c und der Detektoren 17c beobachtet wird.

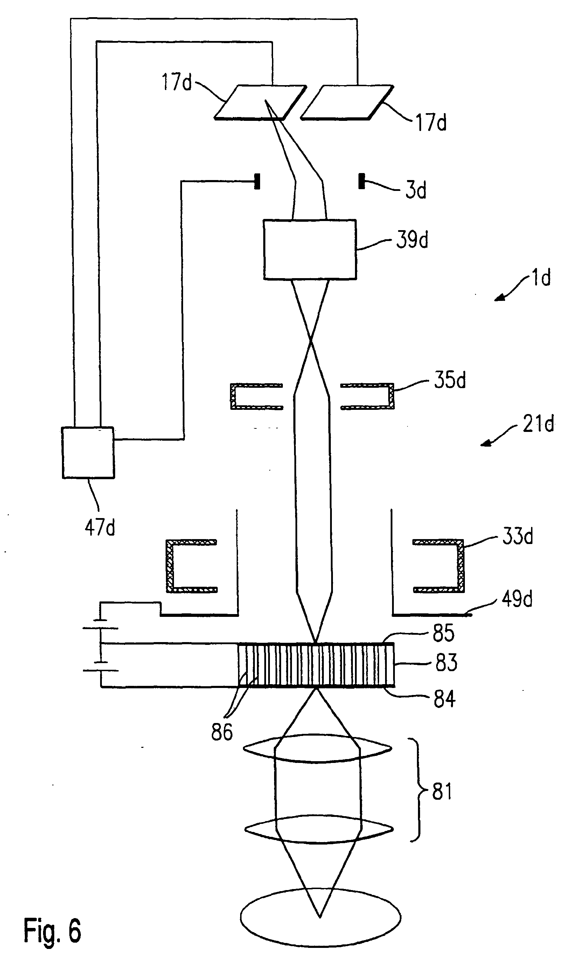

Bei einer in Figur 6 dargestellten Detektoranordnung wird ein Objekt 27d im Unterschied zu den in Zusammenhang mit den Figuren 3, 4 und 5 erläuterten Systemen nicht direkt elektronenoptisch untersucht. Es wird vielmehr das Objekt 27d mittels einer Lichtoptik 81 lichtoptisch auf eine Eingangsseite 84 eines Photonen-Elektronen-Konverters 83 abgebildet. Der Photonen-Elektronen-Konverter 83 ist als Vielkanalplatte ausgebildet, so daß sich zwischen einer Eingangsseite 84 und einer Ausgangsseite 85 desselben eine Vielzahl von Mikroröhren 86 erstreckt. Zwischen der Eingangsseite 84 und der Ausgangsseite 85 ist eine elektrische Hochspannung angelegt, durch welche Photoelektronen, die an der Eingangsseite 84 entstehen, in den Mikroröhren 86 vervielfacht werden und auf der Ausgangsseite 85 aus den Röhren 86 austreten. Die an der Ausgangsseite 85 des Photonen-Elektronen-Konverters 83 austretenden Elektronen werden zunächst mittels einer Elektrode 49d beschleunigt und durch eine Abbildungsoptik 21d, welche zwei Fokussierlinsen 33d und 35d sowie eine Nachvergrößerungsoptik 39d umfaßt, auf Detektoren 17d abgebildet.

Zwischen der Nachvergrößerungsoptik 39d und den Detektoren 17d ist wiederum eine Ablenkeinrichtung 3d angeordnet, um die Ausgangsseite 85 des Konverters 83 wahlweise auf einen Detektor 17d aus der Mehrzahl von Detektoren abzubilden. Die zeitliche Abfolge der Abbildung der Elektronen auf die einzelnen Detektoren und des Auslesens der Detektoren 17d in die Steuerung 47d erfolgt wiederum nach einem Schema, wie dies vorangehend erläutert wurde. Im Unterschied zu einer optischen Beobachtung des Objekts nach einem herkömmlichen Verfahren, bei dem das Objekt optisch dirket auf einen optischen Detektor abgebildet wird, ermöglicht die Elektronendetektoranordnung 1d eine wesentlich höhere Aufnahmerate der aufgenommenen Bilder. Es ist nämlich durch die Zwischenschaltung der elektronenoptischen Ablenkeinrichtung 3d möglich, sehr schnell zwischen mehreren zu belichtenden Detektoren umzuschalten, so daß die erhöhte Zahl von bereitgestellten und nacheinander belichteten Detektoren 17d eine effektive Erhöhung der Bildaufnahmerate ermöglicht.

Zur Erleichterung der Darstellung in den Figuren 3, 4, 5 und 6 wurden dort jeweils lediglich zwei Detektoren als die Mehrzahl von Detektoren dargestellt. Es ist jedoch vorgesehen, die Anzahl der Detektoren in diesen Ausführungsformen derart zu bestimmen, daß nach dem Ende der Belichtungszeitdauer eines jeden der Detektoren ein weiterer Detektor zur Verfügung steht, welcher sich gerade nicht in seinem Totzeitstatus befindet. Entsprechend wird die Anzahl der tatsächlich verwendeten Detektoren bei diesen Ausführungsformen höher liegen. Die Anordnung dieser mehreren Detektoren kann entweder in einer Reihe, das heißt linear nebeneinander, vorgesehen sein, wie dies in den Figuren 3 bis 6 angedeutet ist. Dann ist die Ablenkeinrichtung lediglich zur Auslenkung des Strahls in nur eine einzige Richtung quer zur Strahlrichtung ausgebildet. Andererseits ist es allerdings auch möglich, die Detektoren in einem zweidimensionalen Feld anzuordnen, wie dies in Figur 1 dargestellt ist. Entsprechend ist die Ablenkeinrichtung zur Auslenkung des Strahls in zwei zueinander unabhängige Richtungen senkrecht zur Strahlachse ausgebildet.

Die in den vorangehend beschriebenen Ausführungsformen vorgesehene Ablenkeinrichtung zum Lenken des Strahls auf wahlweise einen der Detektoren aus der Mehrzahl der Detektoren wurde als elektrostatische Ablenkeinrichtung beschrieben. Es ist allerdings möglich, zu diesem Zweck eine magnetische Ablenkeinrichtung vorzusehen, das heißt eine Spulenanordnung, welche ein magnetisches Feld erzeugt, das ablenkend auf den Strahl der geladenen Teilchen wirkt. Vorzugsweise ist dies ein magnetisches Dipolfeld.

In Figur 7 ist eine Variante des in Figur 2 dargestellten Ansteuerschemas für Detektoren dargestellt. Das in Figur 7 gezeigte Ansteuerschema betrifft Detektoren, welche einen Zwischenspeicher aufweisen. Das Ansteuerschema ist in Figur 7 für drei Detektoren, D₁, D₂, und D₃, dargestellt. Mit Beginn des Schemas bei einem Zeitpunkt t₀ wird der Detektor D₁ während einer Belichtungszeitdauer t_{B} belichtet. Nach Ablauf der Belichtungsdauer wird das durch den Detektor D₁ integrierte Bild in den Zwischenspeicher des Detektors D₁ überführt, wie dies durch Pfeile 99 in Figur 7 angedeutet ist. Nach Überführung des zuvor aufgenommenen Bildes in den Zwischenspeicher wird das Bild von dem Zwischenspeicher an die Steuerung übertragen, wozu eine Auslesezeitdauer t_{A} notwendig ist. Allerdings ist der Detektor bereits vor Ende der Übertragung des Bildes aus dem Zwischenspeicher zu der Steuerung wieder bereit für eine neue Belichtung. Bei dem dargestellten Ansteuerschema wird unmittelbar nach der Belichtung des Detektors D₁ der Detektor D₂ belichtet, und nach dem Ende von dessen Belichtungsdauer wird der Detektor D₃ belichtet, dessen Belichtungsdauer mit dem Zeitpunkt t_{E} endet. Hiernach wird der Detektor D₁ erneut belichtet. Die erneute Belichtung des Dektors D₁ beginnt allerdings zu einem Zeitpunkt, zu dem die Übertragung des zuvor belichteten Bildes aus dem Zwischenspeicher zur Steuerung noch nicht abgeschlossen ist. Insgesamt erfolgt die Belichtung der Detektoren D₁, D₂, D₃ zeitlich im wesentlichen lückenlos, so daß die im Strahl geladener Teilchen enthaltene Ortsinformation im wesentlichen ständig detektiert wird. Aufgrund des Zwischenspeichers in dem Detektor kann das Auslesen von Bildinformation aus dem Detektor und dessen Belichtung zeitgleich erfolgen, und eine Totzeitdauer t_{T} des Detektors ist kürzer als die für das Auslesen eines Bildes notwendige Zeitdauer t_{A}.

Die in den vorangehend beschriebenen Ausführungsformen einsetzbaren Detektoren sind beispielsweise herkömmliche CCD (Charged Coupled Device)-Detektoren. Es ist jedoch auch möglich, hier andere Typen von Detektoren einzusetzen. Beispiele hierfür sind CMOS-Active-Pixel-Detektoren oder Random Access Charge Injection Device-Detektoren. Ein CMOS-Active-Pixel-Detektor kann unter der Bezeichnung PB-MV 40 von der Firma Photobit erworben werden, und ein Random Access Charge Injection Device-Detektor kann beispielsweise unter der Bezeichnung RACID 84 von der CIDTECH erworben werden.

Ferner ist es möglich, die Mehrzahl von Detektoren, wie sie im Zusammenhang mit den vorangehend erläuterten Ausführungsformen beschrieben wurden, einzusetzen, um die Funktionstüchtigkeit eines jeden Detektors zu überprüfen. Hierzu wird auf zwei oder mehr Detektoren zeitlich nacheinander ein gleicher Bereich des Objekts abgedeckt. Es sollten in den zwei oder mehreren Detektoren identische Teilbilder entstehen. Durch Vergleich dieser durch die zwei oder mehreren Detektoren gewonnenen Teilbilder miteinander können Differenzen in den Teilbildern ermittelt werden, welche dann auf einen Defekt eines Detektors schließen lassen. Mit diesem Verfahren können also bei einem jeden Detektor aus der Mehrzahl von Detektoren Defekte Bitbereiche, wie etwa Pixelfehler, identifiziert werden. Dieses Verfahren zur Ermittelung eines Fehlers in den Detektoren kann beispielsweise in regelmäßigen oder unbestimmten Zeitabständen wiederholt werden.

In den vorangehend beschriebenen Ausführungsformen ist die Ablenkeinrichtung zwischen den Detektoren und der Nachvergrößerungsoptik gemäß Figuren 3, 4, 5 und 6 bzw. der Magnetlinse 21 gemäß Figur 1 angeordnet. Es ist jedoch auch möglich, die Ablenkeinrichtung im Strahlgang vor einer oder mehreren Komponenten der Nachvergrößerungsoptik bzw. der gesamten Abbildungsoptik anzuordnen oder den Ablenker in die Abbildungsoptik zu integrieren. Es können auch Korrekturkomponenten, wie etwa dynamische Fokusspulen, vorgesehen sein, um durch die Ablenkeinrichtung erzeugte Bildfehler zu kompensieren.

## Patentansprüche

1. Detektoranordnung zur Erfassung einer in einem Strahl (5) geladener Teilchen enthaltenen Ortsinformation, umfassend:
eine Mehrzahl von ortsauflösenden Detektoren (17) zur Ausgabe eines die Ortsinformation umfassenden Bildes einer ortsabhängigen Verteilung an zeitlich integrierter Intensität von auf eine Detektionsfläche (19) der Detektoren (17) treffenden geladenen Teilchen;
eine Steuerung (47) zum Empfang des von der Mehrzahl von Detektoren (17) ausgegebenen Bildes,
**dadurch gekennzeichnet, daß**
eine Ablenkeinrichtung (3) vorgesehen ist, um den Strahl (5) geladener Teilchen auf die Detektionsfläche (19) eines aus der Mehrzahl von Detektoren (17) auswählbaren Detektors (17) zu richten, wobei die Ablenkeinrichtung (3) durch die Steuerung (47) ansteuerbar ist, um den Detektor (17) aus der Mehrzahl von Detektoren (17) auszuwählen, auf den der Strahl (6) zu richten ist.

2. Detektoranordnung nach Anspruch 1, wobei eine Übertragung des Bildes von dem Detektor (17) zu der Steuerung (47) wenigstens eine Totzeitdauer (t_{T}) umfaßt, während der Detektor (17) die auf seine Detektionsfläche (19) treffende Intensität der geladenen Teilchen nicht weiter integriert, wobei die Ablenkeinrichtung (3) von der Steuerung (47) ansteuerbar ist, um während der Totzeitdauer bei der Übertragung des Bildes von einem ersten der mehreren Detektoren (17) zu der Steuerung den Strahl (5) der geladenen Teilchen auf die Detektionsfläche (19) eines von dem ersten Detektor (17) verschiedenen zweiten der mehreren Detektoren (17) zu richten.

3. Detektoranordnung nach Anspruch 2, wobei die Steuerung (47) ferner dazu ausgebildet ist, die Ablenkeinrichtung (3) derart anzusteuern, daß der Strahl (5) zeitlich nacheinander und periodisch wiederkehrend auf die Detektionsflächen (19) der mehreren Detektoren (17) gerichtet ist.

4. Detektoranordnung nach Anspruch 3, wobei für einen jeden der Detektoren (17) eine Belichtungsdauer (t_{B}) vorgesehen ist, während der der jeweilige Detektor (17) die Intensität der auf seine Detektionsfläche (19) treffenden geladenen Teilchen integriert, und wobei eine Anzahl der Detektoren (17) bestimmt ist als ein Verhältnis aus der Totzeitdauer (t_{T}) geteilt durch die Belichtungszeit (t_{B}), und zwar aufgerundet auf die nächst größere ganze Zahl.

5. Detektoranordnung nach einem der Ansprüche 1 bis 4, ferner umfassend eine Abbildungsoptik (21), um ein in einer Objektebene der Abbildungsoptik anordenbares Objekt (27) oder ein Zwischenbild eines Objekts über den Strahl (5) geladener Teilchen auf die Detektionsfläche (19) des wenigstens einen Detektors (17) abzubilden.

6. Detektoranordnung nach Anspruch 5, wobei die Abbildungsoptik (21) dazu ausgebildet ist, einen Teilbereich (31) des Objekts (27) auf die Detektionsfläche (19) abzubilden und wobei die Abbildungsoptik (21) durch die Steuerung (47) ansteuerbar ist, um den auf die Detektionsfläche (19) abgebildeten Teilbereich (31) des Objekts (27) zu ändern.

7. Detektoranordnung nach Anspruch 6, wobei die Steuerung (47) dazu ausgebildet ist, die Änderung des abgebildeten Teilbereichs (31) des Objekts (27) im wesentlichen zeitgleich mit einer Änderung der Auswahl des Detektors (17), auf den der Teilbereich (31) abgebildet ist, durchzuführen.

8. Detektoranordnung nach einem der Ansprüche 5 bis 7, ferner umfassend eine Beleuchtungseinrichtung (63), um wenigstens einem Teilbereich (31) des Objekts (27) Energie derart zuzuführen, daß von Orten des Teilbereichs (31) die geladenen Teilchen austreten, welche als Strahl (5) durch die Abbildungsoptik (21) auf die Detektionsfläche (19) des Detektors (17) gerichtet sind.

9. Detektoranordnung nach Anspruch 8, wobei die Beleuchtungseinrichtung eine Elektronenquelle (63; 63a; 63b) oder eine Photonenquelle (63c) oder eine Ionenquelle umfaßt.

10. Detektoranordnung nach Anspruch 8 oder 9, wobei die geladenen Teilchen Rückstreuelektronen oder Sekundärelektronen oder Transmissionselektronen bzw. Photoelektronen umfassen.

11. Detektoranordnung nach einem der Ansprüche 8 bis 10, wobei die Beleuchtungsanordnung eine durch die Steuerung (47c) ansteuerbare gepulste Beleuchtungsanordnung (63c) ist, wobei die Steuerung (47c) dazu ausgebildet ist, nach einer Änderung der Auswahl des Detektors (17c), auf den der Teilbereich (31c) abgebildet ist, die Beleuchtungseinrichtung (63c) zur Emission eines Energiepulses anzusteuern und daraufhin die Auswahl des Detektors (17c), auf den der Teilbereich (31c) abgebildet ist, erneut zu ändern.

12. Detektoranordnung nach einem der Ansprüche 5 bis 11, wobei das Objekt ein Photonen-Elektronen-Konverter, insbesondere eine Vielkanalplatte (83), ist.

13. Detektoranordnung nach einem der Ansprüche 5 bis 12, wobei die Detektionsflächen (19) der mehreren Detektoren (17) im wesentlichen in einer Bildfläche der Abbildungsoptik (21) angeordnet sind.

14. Detektoranordnung nach einem der Ansprüche 1 bis 13, wobei der Strahl (5a) durch die Ablenkeinrichtung (3a) in eine einzige Ablenkrichtung quer zu einer Strahlrichtung (51) des Strahls (5a) ablenkbar ist und die Detektionsflächen (19a) der mehreren Detektoren (17a) - gesehen in der Strahlrichtung (51) - in einer Reihe nebeneinander angeordnet sind.

15. Detektoranordnung nach einem der Ansprüche 1 bis 13, wobei der Strahl (5) durch die Ablenkeinrichtung in zwei quer zueinander und zu einer Strahlrichtung (z) des Strahls orientierte Ablenkrichtungen (x, y) ablenkbar ist und die Detektionsflächen (19) der mehreren Detektoren (17) - gesehen in der Strahlrichtung - in einem Feld in mehreren Richtungen nebeneinander angeordnet sind.

16. Detektoranordnung nach einem der Ansprüche 1 bis 15, wobei der wenigstens eine Detektor ein HalbleiterDetektor, insbesondere ein CCD-Detektor oder/und ein CID-Detektor ist.

17. Verfahren zum Erstellen eines Bildes eines zu beobachtenden Objekts, umfassend:
Verwenden einer Mehrzahl von ortsauflösenden Detektoren zur zeitlichen Integration einer auf eine Detektionsfläche des Detektors treffenden ortsabhängigen Intensität eines Strahls geladener Teilchen während einer Belichtungsdauer des Detektors und zur Ausgabe eines Bildes der integrierten Intensität, wobei der Detektor während wenigstens eines Teils einer zu der Ausgabe des Bildes nötigen Zeitdauer sich in einem Totzeitstatus befindet, in dem er die Intensität nicht integriert,
Verwenden eines Speichers zur Aufnahme einer Mehrzahl von den Detektoren ausgegebenen Bildern,
Abbilden wenigstens eines Teilbereichs des Objekts auf die Detektionsfläche eines aus der Mehrzahl von Detektoren gerade ausgewählten Detektors durch den Strahl geladener Teilchen und Integration der ortsabhängigen Intensität des Strahls durch den gerade ausgewählten Detektor,
Bestimmen eines von dem gerade ausgewählten Detektor verschiedenen Detektors aus der Mehrzahl von Detektoren zum neu ausgewählten Detektor,
Übertragen des Bildes von dem zuvor ausgewählten Detektor in einen Speicherbereich des Speichers nach einem Ende der Belichtungsdauer des zuvor ausgewählten Detektors,
Abbilden des wenigstens einen Teilbereichs des Objekts auf die Detektionsfläche des neu ausgewählten Detektors durch den Strahl geladener Teilchen und Integration der ortsabhängigen Intensität des Strahls durch den neu ausgewählten Detektor und während der Übertragung des Bildes von dem zuvor ausgewählten Detektor in den Speicherbereich des Speichers,
Übertragen des Bildes von dem neu ausgewählten Detektor in einen Speicherbereich des Speichers, der von dem Speicherbereich verschieden ist, in den das Bild des zuvor ausgewählten Detektors übertragen wird, nach einem Ende der Belichtungsdauer des neu ausgewählten Detektors.

18. Verfahren nach Anspruch 17, wobei bei der Bestimmung des neu ausgewählten Detektors ein solcher Detektor aus der Mehrzahl von Detektoren ausgewählt wird, der sich nicht in dem Totzeitstatus befindet.

19. Verfahren nach Anspruch 17 oder 18, wobei der auf die Detektionsfläche des gerade ausgewählten Detektors abgebildete Teilbereich des Objekts verschieden ist von dem auf die Detektionsfläche des zuvor ausgewählten Detektors abgebildeten Teilbereich des Objekts.

20. Verfahren nach Anspruch 19, wobei die in die mehreren Speicherbereiche übertragenen Bilder der mehreren Teilbereiche des Objekts zu einem Gesamtbild des Objekts zusammengefügt und ausgegeben werden.

21. Verfahren nach einem der Ansprüche 17 bis 20, ferner umfassend:
Bereitstellen einer gepulsten Beleuchtungseinrichtung, um wenigstens dem Teilbereich des Objekts Energie derart zuzuführen, daß von Orten des Teilbereichs die geladenen Teilchen austreten, welche als Strahl auf die Detektionsfläche des Detektors abgebildet werden,
wobei die Emission von Energiepulsen durch die Beleuchtungseinrichtung und die Bestimmung des von dem gerade ausgewählten Detektor verschiedenen Detektors zum neu ausgewählten Detektor zeitlich miteinander synchronisiert sind.

22. Verfahren nach einem der Ansprüche 17 bis 21, wobei das abgebildete Objekt eine Mehrzahl von Bauelementen, insbesondere Halbleiterbauelementen auf einem Halbleiterwafer, oder/und einen Photonen-Elektronen-Konverter, insbesondere eine Vielkanalplatte, umfaßt.

23. Verfahren nach einem der Ansprüche 17 bis 22, wobei auf wenigstens zwei Detektoren aus der Mehrzahl von Detektoren ein jeweils gleicher Teilbereich des Objekts abgebildet wird, und die von den wenigstens zwei Detektoren hierbei gewonnenen Bilder miteinander verglichen werden, um eine Information in Bezug auf einen möglichen Defekt eines der wenigstens zwei Detektoren zu ermitteln.

## Claims

1. A detector arrangement for detecting position information contained in a beam (5) of charged particles, comprising:
a plurality of position-sensitive detectors (17) for outputting an image containing the position information of a position-dependent distribution of intensity, integrated in terms of time, of charged particles impinging on a detection area (19) of the detectors (17), and
a controller (47) for receiving the image outputted by the plurality of detectors (17),
**characterized in that**
a deflector (3) is provided to direct the beam (5) of charged particles to the detection area (19) of a detector (17) selectable from the plurality of detectors (17), the deflector (3) being controllable by the controller (47) to select the detector (17) from the plurality of detectors (17) to which the beam (6) is to be directed.

2. The detector arrangement according to claim 1, wherein a transmission of the image from the detector (17) to the controller (47) comprises at least a dead time (t_{T}) during which the detector (17) does not integrate the intensity of charged particles impinging on its detection area (19) any further, the deflector (3) being controllable by the controller (47) to direct, during the dead time in the transmission of the image from a first one of the plurality of detectors (17) to the controller, the beam (5) of charged particles to the detection area (19) of a second one of the plurality of detectors (17) which is different from the first detector (17).

3. The detector arrangement according to claim 2, wherein the controller (47) is further adapted for controlling the deflector (3) such that the beam (5) is directed successively in time and periodically recurrently to the detection areas (19) of the plurality of detectors (17).

4. The detector arrangement according to claim 3, wherein an exposure time (t_{B}) is provided for each one of the detectors (17) during which the respective detector (17) integrates the intensity of the charged particles impinging on its detection area (19), and wherein a number of the detectors (17) is determined as a ratio of the dead time (t_{T}) divided by the exposure time (t_{B}), rounded up to the next higher integer.

5. The detector arrangement according to one of claims 1 to 4, further comprising an optical imaging system (21) for imaging an object (27) disposable in an object plane of the optical imaging system or an intermediate image of an object by means of a beam (5) of charged particles on the detection area (19) of the at least one detector (17).

6. The detector arrangement according to claim 5, wherein the optical imaging system (21) is adapted for imaging a partial region (31) of the object (27) on the detection area (19) and wherein the optical imaging system (21) is controllable by the controller (47) to change the partial region (31) of the object (27) imaged on the detection area (19).

7. The detector arrangement according to claim 6, wherein the controller (47) is adapted for carrying out the change of the imaged partial region (31) of the object (27) substantially simultaneously with a change of the selection of the detector (17) on which the partial region (31) is imaged.

8. The detection arrangement according to one of claims 5 to 7, further comprising an illumination system (63) for supplying energy to at least a partial region (31) of the object such that the charged particles emanate from positions of the partial regions (31) and are directed as beam (5) through the optical imaging system (21) to the detection area (19) of the detector (17).

9. The detector arrangement according to claim 8, wherein the illumination system comprises an electron source (63; 63a; 63b) or a photon source (63c) or an ion source.

10. The detector arrangement according to claim 8 or 9, wherein the charged particles comprise backscattering electrons or secondary electrons or transmission electrons or photoelectrons, respectively.

11. The detector arrangement according to one of claims 8 to 10, wherein the illumination system is a pulsed illumination system (63c) controllable by the controller (47c), the controller (47c) being adapted for controlling the illumination system (63a) to emit an energy pulse after a change of the selection of the detector (17c) on which the partial region (31c) is imaged has occurred and, subsequently, to change the selection of the detector (17c) again on which the partial region (31c) is imaged.

12. The detector arrangement according to one of claims 5 to 11, wherein the object is a photon/electron converter, in particular a multi-channel plate (83).

13. The detector arrangement according to one of claims 5 to 12, wherein the detection areas (19) of the plurality of detectors (17) are substantially disposed in an image area of the optical imaging system (21).

14. The detector arrangement according to one of claims 1 to 13, wherein the beam (5a) is deflectable by the deflector (3a) into a single deflection direction transverse to a beam direction (51) of the beam (5a) and the detection areas (19a) of the plurality of detectors (17a) - seen in beam direction (51) - are disposed in a row side-by-side.

15. The detector arrangement according to one of claims 1 to 13, wherein the beam (5) is deflectable into two directions (x, y) oriented transversely to each other and to a beam direction (z) of the beam and the detection areas (19) of the plurality of detectors (17) - seen in beam direction - are disposed in a field side by side in several directions.

16. The detection arrangement according to one of claims 1 to 15, wherein the at least one detector is a semiconductor detector, in particular, a CCD detector or/and a CID detector.

17. A method for forming an image of an object to be observed, comprising:
using a plurality of position-sensitive detectors for integrating, in terms of time, a position-dependent intensity of a beam of charged particles impinging on a detection area of the detector during an exposure time of the detector and for outputting an image of the integrated intensity, the detector being in a dead time state during at least a part of the time required for outputting the image, during which dead time the detector does not integrate the intensity,
using a memory for receiving a plurality of images supplied by the detectors,
imaging at least a partial region of the object on the detection area of a currently selected one of the plurality of detectors by the beam of charged particles and integrating the position-dependent intensity of the beam by the currently selected detector,
determining a detector of the plurality of detectors as newly selected detector which is different from the currently selected detector,
transmitting the image of the previously selected detector to a memory area of the memory after the exposure time of the previously selected detector has elapsed,
imaging the at least one partial region of the object on the detection area of the newly selected detector by the beam of charged particles and integrating the position-dependent intensity of the beam by the newly selected detector and during the transmission of the image from the previously selected detector to the memory area of the memory,
after termination of the exposure time of the newly selected detector, transmitting the image from the newly selected detector to a memory area of the memory which is different from the memory area to which the image of the previously selected detector is transmitted

18. The method according to claim 17, wherein, in determining the newly selected detector, a detector is selected from the plurality of detectors which is not in the dead time state.

19. The method according to claim 17 or 18, wherein the partial region of the object which is imaged on the detection area of the currently selected detector is different from the partial region of the object imaged on the detection area of the previously selected detector.

20. The method according to claim 19, wherein the images of the plurality of partial regions of the object transmitted to the plurality of memory areas are composed to, and outputted as, a full image of the object.

21. The method according to one of claims 17 to 20, further comprising:
providing a pulsed illumination system for supplying energy to at least the partial region of the object such that the charged particles emanate from positions of the partial region which are imaged as beam on the detection area of the detector,
wherein the emission of energy pulses by the illumination system and the determination of the newly selected detector which is different from the currently selected detector are synchronized in time with each other.

22. The method according to one of claims 17 to 21, wherein the imaged object comprises a plurality of devices, in particular semiconductor devices on a semiconductor wafer, or/and a photon/electron converter, in particular, a multi-channel plate.

23. The method according to one of claims 17 to 22, wherein the same partial region of the object is imaged on at least two detectors of the plurality of detectors, and the images thus obtained from the at least two detectors are compared with each other to obtain information in respect of a possible defect of at least one of the two detectors.

## Revendications

1. Dispositif détecteur pour la détection d'une information de position contenue dans un faisceau (5) de particules chargées, comprenant :
une pluralité de détecteurs à résolution de position (17) pour la sortie d'une image, comprenant l'information de position, d'une distribution fonction de la position de l'intensité intégrée dans le temps de particules chargées rencontrant une surface de détection (19) des détecteurs (17) ;
une commande (47) pour la réception de l'image sortie par la pluralité des détecteurs (17),
**caractérisé en ce que**
un dispositif de déviation (3) est prévu pour diriger le faisceau (5) de particules chargées sur la surface de détection (19) d'un détecteur (17) pouvant être sélectionné parmi la pluralité de détecteurs (17), le dispositif de déviation (3) pouvant être commandé par la commande (47) pour sélectionner parmi la pluralité de détecteurs (17) le détecteur (17) sur lequel le faisceau (6) doit être dirigé.

2. Dispositif détecteur selon la revendication 1, une transmission de l'image du détecteur (17) à la commande (47) comprenant au moins une durée de temps mort (t_{T}) pendant laquelle le détecteur (17) ne continue pas d'intégrer l'intensité des particules chargées rencontrant sa surface de détection (19), le dispositif de déviation (3) pouvant être commandé par la commande (47) pour diriger le faisceau (5) de particules chargées sur la surface de détection (19) d'un deuxième desdits plusieurs détecteurs (17) différent du premier détecteur (17) pendant la durée de temps mort lors de la transmission à la commande de l'image d'un premier desdits plusieurs détecteurs (17).

3. Dispositif détecteur selon la revendication 2, la commande (47) étant en outre configurée en vue de commander le dispositif de déviation (3) de telle sorte que le faisceau (5) soit dirigé successivement et d'une façon se répétant périodiquement sur les surfaces de détection (19) desdits plusieurs détecteurs (17).

4. Dispositif détecteur selon la revendication 3, un temps d'exposition (t_{B}) étant prévu pour chacun des détecteurs (17), pendant lequel le détecteur (17) respectif intègre l'intensité des particuliers chargés rencontrant sa surface de détection (19), et un nombre de détecteurs (17) étant déterminé comme un rapport de la durée de temps mort (t_{T}) divisée par le temps d'exposition (t_{B}), et ce, arrondi au nombre entier immédiatement supérieur.

5. Dispositif détecteur selon l'une des revendications 1 à 4, comprenant en outre une optique de reproduction (21) pour reproduire sur la surface de détection (19) dudit au moins un détecteur (17), par l'intermédiaire du faisceau (5) de particules chargées, un objet (27) ou une image intermédiaire d'un objet pouvant être disposé dans un plan d'objet de l'optique de reproduction.

6. Dispositif détecteur selon la revendication 5, l'optique de reproduction (21) étant réalisée en vue de reproduire une zone partielle (31) de l'objet (27) sur la surface de détection (19) et l'optique de reproduction (21) pouvant être commandée par la commande (47) pour modifier la zone partielle (31) de l'objet (27) reproduite sur la surface de détection (19).

7. Dispositif détecteur selon la revendication 6, la commande (47) étant réalisée en vue d'effectuer la modification de la zone partielle (31) reproduite de l'objet (27) sensiblement en même temps qu'une modification de la sélection du détecteur (17) sur lequel la zone partielle (31) est reproduite.

8. Dispositif détecteur selon l'une des revendications 5 à 7, comprenant en outre un dispositif d'éclairage (63), pour acheminer de l'énergie à au moins une zone partielle (31) de l'objet (27), de telle sorte que les particules chargées sortent d'emplacements de la zone partielle (31), particules qui sont dirigées comme faisceau (5) par l'optique de reproduction (21) sur la surface de détection (19) du détecteur (17).

9. Dispositif détecteur selon la revendication 8, le dispositif d'éclairage comprenant une source d'électrons (63 ; 63a ; 63b) ou une source de photons (63c) ou une source d'ions.

10. Dispositif détecteur selon la revendication 8 ou 9, les particules chargées comprenant des électrons rétrodiffusés ou des électrons secondaires ou des électrons de transmission, respectivement des photoélectrons.

11. Dispositif détecteur selon l'une des revendications 8 à 10, le dispositif d'éclairage étant un dispositif d'éclairage pulsé (63c) pouvant être piloté par la commande (47c), la commande (47c) étant réalisée en vue de piloter le dispositif d'éclairage (63c) pour l'émission d'une impulsion d'énergie après une modification de la sélection du détecteur (17c) sur lequel la zone partielle (3 1 c) est reproduite, et ensuite de modifier de nouveau la sélection du détecteur (17c) sur lequel la zone partielle (31c) est reproduite.

12. Dispositif détecteur selon l'une des revendications 5 à 11, l'objet étant un convertisseur photons-électrons, en particulier une plaque multicanaux (83).

13. Dispositif détecteur selon l'une des revendications 5 à 12, les surfaces de détection (19) desdits plusieurs détecteurs (17) étant disposées sensiblement dans un plan d'image de l'optique de reproduction (21).

14. Dispositif détecteur selon l'une des revendications 1 à 13, le faisceau (5a) pouvant être dévié par le dispositif de déviation (3a) dans une seule direction de déviation transversalement à une direction de faisceau (51) du faisceau (5a) et dans lequel les surfaces de détection (19a) desdits plusieurs détecteurs (17a) - vues dans le sens du faisceau (51) - sont disposées dans une rangée les unes à côté des autres.

15. Dispositif détecteur selon l'une des revendications 1 à 13, le faisceau (5) pouvant être dévié par le dispositif de déviation dans deux directions de déviation (x, y) orientées transversalement l'une à l'autre et à une direction de faisceau (z) du faisceau, et les surfaces de détection (19) desdits plusieurs détecteurs (17) - vues dans le sens du faisceau - étant disposées dans un champ dans plusieurs directions les unes à côté des autres.

16. Dispositif détecteur selon l'une des revendications 1 à 15, ledit au moins un détecteur étant un détecteur à semi-conducteur, en particulier un détecteur CCD et/ou un détecteur CID.

17. Procédé pour l'obtention d'une image d'un objet à observer, comprenant :
La mise en oeuvre d'une pluralité de détecteurs à résolution de position pour l'intégration en fonction du temps d'une intensité, fonction de la position, d'un faisceau de particules chargées rencontrant une surface de détection du détecteur pendant une durée d'exposition du détecteur, et pour la sortie d'une image de l'intensité intégrée, le détecteur se trouvant pendant au moins une partie d'une durée de temps nécessaire à la sortie de l'image dans un état de temps mort dans lequel il n'intègre pas l'intensité,
La mise en oeuvre d'une mémoire pour l'enregistrement d'une pluralité d'images fournies par les détecteurs,
la reproduction, par le faisceau de particules chargées, d'au moins une zone partielle de l'objet sur la surface de détection d'un détecteur momentanément sélectionné parmi la pluralité de détecteurs, et l'intégration de l'intensité du faisceau fonction de la position par le détecteur momentanément sélectionné,
la détermination comme détecteur nouvellement sélectionné parmi la pluralité de détecteurs d'un détecteur différent du détecteur momentanément sélectionné,
le transfert de l'image du détecteur précédemment sélectionné dans une zone de mémoire de la mémoire après une fin de la durée d'exposition du détecteur précédemment sélectionné,
la reproduction, par le faisceau de particules chargées, de ladite au moins une zone partielle de l'objet sur la surface de détection du détecteur nouvellement sélectionné, et l'intégration de l'intensité, fonction de la position, du faisceau par le détecteur nouvellement sélectionné et, pendant la transmission de l'image du détecteur précédemment sélectionné dans la zone de mémoire de la mémoire,
la transmission de l'image du détecteur nouvellement sélectionné dans une zone de mémoire de la mémoire qui est différente de la zone de mémoire dans laquelle est transmise l'image du détecteur précédemment sélectionné, après une fin de la durée d'exposition du détecteur nouvellement sélectionné.

18. Procédé selon la revendication 17, un détecteur qui ne se trouve pas dans l'état de temps mort étant sélectionné parmi la pluralité de détecteurs, lors de la détermination du détecteur nouvellement sélectionné.

19. Procédé selon la revendication 17 ou 18, la zone partielle de l'objet reproduite sur la surface de détection du détecteur momentanément sélectionné étant différente de la zone partielle de l'objet qui est reproduite sur la surface de détection du détecteur sélectionné précédemment.

20. Procédé selon la revendication 19, les images desdites plusieurs zones partielles de l'objet transmises dans lesdites plusieurs zones de mémoire étant assemblées en une image globale de l'objet et sont sorties.

21. Procédé selon l'une des revendications 17 à 20, comprenant en outre :
la mise à disposition d'un dispositif d'éclairage pulsé pour acheminer de l'énergie au moins à la zone partielle de l'objet de telle sorte que les particules chargées qui sont reproduites comme faisceau sur la surface de détection du détecteur sortent depuis des emplacements de la zone partielle,
l'émission d'impulsions d'énergie par le dispositif d'éclairage et la détermination, comme détecteur nouvellement sélectionné, du détecteur différent du détecteur momentanément sélectionné étant synchronisées dans le temps l'une avec l'autre.

22. Procédé selon l'une des revendications 17 à 21, l'objet reproduit comprenant une pluralité d'éléments de construction, en particulier d'éléments de construction à semi-conducteurs sur une galette de semi-conducteurs, et/ou un convertisseur photons-électrons, en particulier une plaque multicanaux.

23. Procédé selon l'une des revendications 17 à 22, une zone partielle respectivement identique de l'objet étant reproduite sur au moins deux détecteurs parmi la pluralité de détecteurs, et les images obtenues ce faisant par lesdits au moins deux détecteurs étant comparées l'une à l'autre pour déterminer une information du point de vue d'un défaut possible de l'un desdits au moins deux détecteurs.
